# EUROPEAN PATENT APPLICATION

(11) **EP 4 506 757 A1**
(43) Date of publication of application: **12.02.2025**
(21) Application number: 23785023.5
(22) Date of filing: 06.04.2023
(51) Int. Cl.: G03F 7/20

(54) **LITHOGRAPHY DEVICE USING ELECTRONIC LAYER IN VACUUM SYSTEM**

(30) Priority: 06.04.2022 KR 20220042855
(71) Applicant: Derkwoo Semitech Co., Ltd., Seoul 06161 (KR)
(72) Inventor: KIM, Ki Bum, Seoul 06082 (KR)
(74) Representative: AWA Sweden AB
(86) International application number: PCT/KR2023/004667
(87) International publication number: WO 2023/195799

(57) **Abstract**

The present invention relates to a device for preventing the adsorption of fine particles onto a mask in a lithography device using a vacuum system and, more specifically, to an extreme ultraviolet lithography device that does not use a pellicle in membrane form. An embodiment of the lithography device according to the present invention comprises: a light-source-unit chamber in which a light source for lithography is disposed; a substrate-unit chamber in which is disposed a substrate on which lithography processing is performed by the light source for lithography; a connection unit which connects the light-source-unit chamber and the substrate-unit chamber and through which light generated by the light source for lithography travels; and a barrier module that is mounted to at least one of the connection unit, the light-source-unit chamber adjacent to the connection unit, and the substrate-unit chamber adjacent to the connection unit, to prevent particles present in the light-source unit chamber from moving to the substrate-unit chamber, wherein the barrier module is an electrical potential barrier, not a physical barrier.

## Description

The present disclosure relates to a device designed to prevent fine particles from being adsorbed onto a mask in a lithography device using vacuum system and more particularly, an extreme ultraviolet (EUV) lithography device not using a membrane type pellicle.

During manufacturing processes of semiconductor devices, a process of depositing a thin film on a semiconductor wafer or etching the deposited thin film on the semiconductor wafer by various methods such as physical deposition or chemical deposition may be accompanied. The depositing process or the etching process is typically performed in a vacuum chamber. However, if dusts which have flowed from outside during the depositing process or the etching process or fine particles produced in the vacuum chamber may be adsorbed onto the semiconductor wafer, the manufactured device may be unable to operate appropriately, thereby leading to a degradation of yields of the semiconductor manufacturing processes.

In addition, a patterning process is required to form an integrated circuit using the deposited thin film, and a method called photolithography may be used as a patterning process. During the photolithography, a photomask may be used as a template for the patterning, and at least one pattern on the photomask may be imprinted onto the wafer. However, if the photomask has undesirably adsorbed the dusts or the fine particles, the imprinted pattern may be damaged because light is absorbed therein or reflected thereby due to these elements thereon, thereby decreasing a performance or the yield of the semiconductor device.

Therefore, overall procedures of the semiconductor process integration are typically conducted in a clean room, however, because of the dusts in the clean room and the fine particles produced during the semiconductor process integration, a membrane type pellicle is attached with a specific distance from the photomask in order to prevent the dusts or the fine particles from being adsorbed. In this case, the dusts or the fine particles are not directly adsorbed on a surface of the photomask but on the pellicle membrane. Since a focal point is still matched with the pattern of the photomask during the lithography process even if the dusts are adsorbed on the pellicle, the dusts on the pellicle do not correspond to the focal point and thus are not imprinted to the pattern.

Since the pellicle should have high transmittance for exposure light, the pellicle is configured with a very thin membrane. In particular, as the development of the micropatterning process is in progress, a resolution power of the lithography becomes proportional to a wavelength used for the lithography, and thus an EUV (Extreme UltraViolet) lithography device with a wavelength of 13.5 nm has been developed from a conventional lithography device using ArF wavelength. To achieve continuous scaling-down of the semiconductor pattern, it is expected that the lithography device will use a shorter wavelength gradually. The problem is that because of a high absorbance of the EUV light at the time of penetrating air layer or material, the lithography device must be operated in a vacuum device. In addition, a membrane structure with an extremely thin film of tens of nanometers or less should be used in order to guarantee the transmittance higher than a certain value when manufacturing the pellicle. The thin membrane type pellicle as such has a problem in that the thin film may be damaged or droop because of impacts from outside or stresses at the thin film itself. Further, the pellicle should not be corroded by hydrogen radicals generated during the processes of the lithography and be thermostable to cope with temperature increased by absorbing EUV wavelength. In particular, since the damage or the drooping of the thin film can distort the image during the pattern imprinting process, the mechanical strength of the thin film of the pellicle should be maintained in order to sustain a complete flat state thereof without the drooping or the damage.

For this matter, a method of assigning an adequate tensile stress to the film itself or a method of additionally forming a supporting layer to prevent the thin film of the pellicle from being distorted may be adopted. However, the method not only complicates the pellicle manufacturing process, but also causes problems such as a decrease in the transmittance properties of the thin film of the pellicle due to the addition of the supporting layer, thereby making the development of the pellicle for extreme ultraviolet lithography difficult. Therefore, it is necessary to develop a new type lithography device that prevents the fine particles or the dusts from being adsorbed to the mask even without using the membrane type pellicle.

It is an object of the present disclosure for solving such conventional problems to provide a lithography device without using a membrane type pellicle, wherein the lithography device prevents dusts or fine particles existing in a chamber from transferring to a mask by installing an electrical potential barrier configured with an electronic layer in the chamber where a light source for lithography is placed.

In order to accomplish objects above, representative structures of the present disclosure are described as follows:
In accordance with one aspect of the present disclosure there is provided a lithography device installed within the vacuum chamber to solve the technical problem above, including: a light-source-unit chamber where a light source for lithography is placed; a mask-unit chamber where a mask is placed, wherein the mask is irradiated by light generated at the light source for lithography; a connection unit which connects the light-source-unit chamber with the mask-unit chamber, and through which light generated at the light source for lithography propagates; and a barrier module which is installed in at least one of the connection unit, the light-source-unit chamber adjacent to the connection unit and the mask-unit chamber adjacent to the connection unit, wherein the barrier module is not a physical barrier but an electrical potential barrier serving to prevent particles located in the light-source-unit chamber from transferring to the mask-unit chamber.

As one example, the barrier module is installed within the light-source-unit chamber adjacent to the connection unit.

As one example, the lithography device further comprises: an additional barrier module which is installed within the mask-unit chamber, wherein the additional barrier module is not a physical barrier but an electrical potential barrier serving to prevent the particles from transferring to the mask which is placed within the mask-unit chamber.

As one example, at least one aperture connected with outside is formed on the mask-unit chamber, wherein the lithography device further comprises: a sub barrier module which is installed around the aperture, wherein the sub barrier module is not a physical barrier but an electrical potential barrier serving to prevent the particles from introducing into the mask chamber through the aperture from the outside.

As one example, the barrier module includes: an electron beam generator installed at one point in the light-source-unit chamber; and an electron beam receptor, installed at another point facing the one point in the light-source-unit-chamber, wherein the electron beam receptor receives electron beams generated at the electron beam generator.

As one example, the lithography device further comprises: a particle capturing module, installed around the barrier module, which captures the particles.

As one example, the particle capturing module is installed at least one of a one-area where the light source is placed with respect to the barrier module and an opposite-area where the light source is not placed with respect to the barrier module.

As one example, the particle capturing module is an electrostatic trap.

As one example, the particles are dusts and fine particles which are produced during at least one process.

As one example, the particles are the dusts and Sn particles.

As one example, the light source for lithography is an EUV (Extreme Ultraviolet) light source.

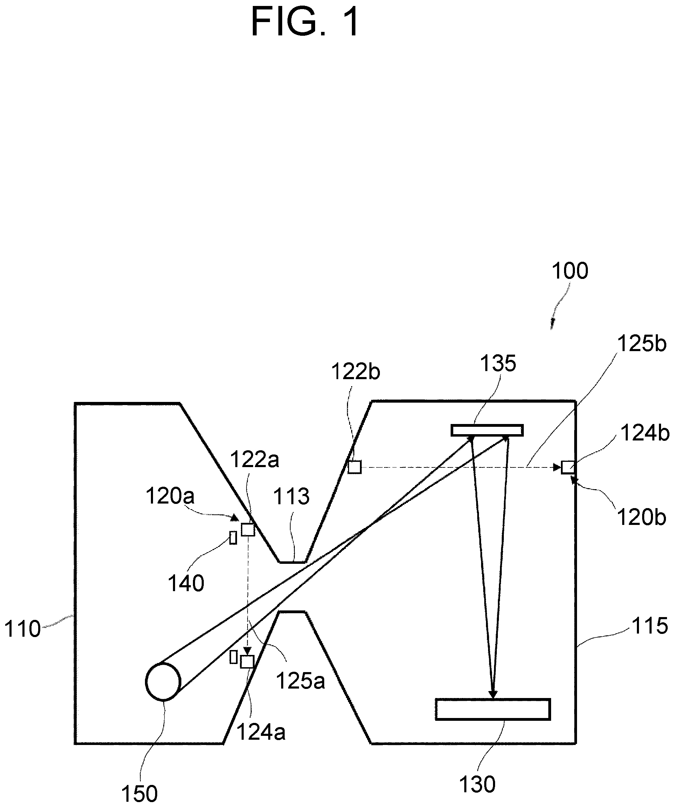

Fig. 1 is a drawing schematically illustrating a lithography device in accordance with one example embodiment of the present disclosure.

Hereinafter, embodiments of the present disclosure will be described in detail with reference to the accompanying drawings. The embodiments of the present disclosure are provided so that those skilled in the art with a more complete description of the present disclosure, and the following embodiments may be modified in various other forms, however, the scope of the present disclosure is not limited to the following embodiments. Rather, these embodiments are provided to make the present disclosure more faithful and complete and to fully introduce the spirit of the present disclosure to those skilled in the art.

In the drawings, for example, variations in the depicted shapes may be expected depending on manufacturing techniques and/or tolerances. Accordingly, the embodiments of the present disclosure should not be construed as being limited to the specific shapes of regions disclosed in the present disclosure, but should include, for example, changes in shapes resulting from manufacturing the same. The same reference numerals are assigned to similar parts throughout the specification. Furthermore, various elements and areas in the drawings are schematically drawn. Accordingly, the present disclosure is not limited by the relative sizes or spacing drawn in the accompanying drawings.

The present disclosure relates to a lithography device for preventing various types of particles, such as fine particles or dusts generated at a light source for lithography or produced during a lithography process, from transferring to a mask by using a barrier module comprised of an electrical potential barrier rather than a physical barrier, and in particular, to prevent the particles like the dusts or the fine particles produced during the process from transferring to the mask by the electrical potential barrier rather than by physical collision with the barrier module. In present disclosure, the physical barrier is a barrier that mainly blocks the movement of the particles by physical collision, meaning a barrier having an actual shape, while the electrical potential barrier means a barrier that blocks the movement of the particles by, for example, coulomb force, rather than the physical collision. Herein, the barrier module can be various types of the electrical potential barrier capable of preventing a transfer of the particles while electrically dividing a certain area from another area. For example, the barrier module includes a plurality of electron beams spaced apart by a predetermined distance. To this end, the barrier module can be comprised of an electron beam generator and an electron beam receptor which receives the electron beams generated at the electron beam generator.

The lithography device as such can prevent the particles such as the dusts or Sn particles existing in an area where the light source for lithography is placed from transferring to the mask, thereby making it possible to dispense with the use of a pellicle in an EUV lithography device. Hereinafter, the lithography device according to one example embodiment of the present disclosure will be described with reference to the drawings.

Fig. 1 is a drawing schematically illustrating a lithography device in accordance with one example embodiment of the present disclosure.

Referring to Fig. 1, a lithography device 100 in accordance with one example embodiment of the present disclosure includes a light-source-unit chamber 110, a mask-unit chamber 115, e.g., a substrate-unit chamber, a connection unit 113, a barrier module 120a, an additional barrier module 120b, a sub barrier module (not shown), and a particle capturing module 140.

The light-source-unit chamber 110 has an accommodation part formed therein, and a light source for lithography 150 is placed inside the light-source-unit chamber 110. The inside of the light-source-unit chamber 110 can be evacuated by a vacuum pump (not shown) and maintained as a vacuum condition. The light source for lithography 150 can be an EUV (Extreme Ultraviolet) light source, but is not limited thereto, and a different light source with a shorter wavelength than the EUV light can be used.

The mask-unit chamber 115 has an accommodation part formed therein, and a mask 135 is placed inside the mask-unit chamber 115, so that light generated at the light source for lithography 150 is irradiated onto the mask 135. Further, light irradiated onto the mask 135 is irradiated onto a wafer 130. Photoresist may be coated on the wafer 130. The inside of the mask-unit chamber 115 can be evacuated by the vacuum pump (not shown) and maintained as a vacuum condition. At least one aperture (not shown) connected with outside may be formed on the mask-unit chamber. For example, an aperture in the form of an exhaust connected to the vacuum pump may be formed on the mask-unit chamber 115, or an aperture in the form of a wafer handling port through which the wafer 130 is loaded and unloaded may be formed. A lens (not shown) may be installed inside the mask-unit chamber 115 so that light generated at the light source for lithography 150 may reach the mask 135. In addition, the lens (not shown) may be installed inside the mask-unit chamber 115 so that light irradiated onto the mask 135 may be irradiated onto the wafer 130. Herein, a plurality of lenses may be installed as the case may be. A pellicle may be formed on the mask 135 as needed.

The connection unit 113 connects the light-source-unit chamber 110 and the mask-unit chamber 115, thereby allowing the light generated at the light source for lithography 150 to travel from the light-source-unit chamber 110 to the mask-unit chamber 115. In Fig. 1, the connection unit 113 is expressed only in the form of a passage connecting the light-source-unit chamber 110 and the mask-unit chamber 115, but is not limited thereto. As another example, the connection unit 113 may be in the form of an intermediated chamber that connects the light-source-unit chamber 110 and the mask-unit chamber 115. Herein, various lenses may be provided within the intermediate chamber, thereby allowing the light generated at the light source for lithography 150 to travel from the light-source-unit chamber 110 to the mask-unit chamber 115.

The barrier module 120a is disposed to prevent the particles such as the dusts or the Sn particle existing in the light-source-unit chamber 110 from transferring to the mask-unit chamber 115. In Fig. 1, the barrier module 120a is illustrated as being installed inside the light-source-unit chamber 110 adjacent to the connection unit 113, but is not limited thereto, and the barrier module 120a may be installed inside the connection unit 113 or may be installed inside the mask-unit chamber 115 adjacent to the connection unit 113. In addition, a plurality of barrier modules 120a may be installed, and may be installed in all of the connection unit 113, the light-source-unit chamber 110, and the mask-unit chamber 115.

The barrier module 120a is comprised of an electrical potential barrier rather than a physical barrier. For example, as illustrated in Fig. 1, at least one electron beams 125a may be used as the barrier module 120a, and the electron beams 125a generated by a one-dimensional charged particle generator may be used. Herein, each of the electron beams 125a may be spaced apart with its adjacent electron beam(s) by a predetermined distance. The electron beams 125a are generated at an electron beam generator 122a, irradiated into the light-source-unit chamber 110, and received by an electron beam receptor 124a. The number, the predetermined distance, an arrangement, an electron beam energy, etc. of the electron beams 125a may be determined as optimized values to prevent movement of the particles. In addition, although Fig. 1 illustrates the plurality of electron beams 125a arranged on the same plane, the present disclosure is not limited thereto. As another example each of the plurality of electron beams 125a may be located on each different planes or on two or more layers.

In this way, the particles such as the dusts or the Sn particles existing in the light-source-unit chamber 110 are prevented from transferring to the mask-unit chamber 115 by the plurality of electron beams 125a. When the particles such as the dusts or the Sn particles existing in the light-source-unit chamber 110 have a negative (-) charge, they are prevented from transferring to the mask-unit chamber 115 through the electron beams 125a, by the electrical potential barrier of the barrier module 120a comprised of the plurality of electron beams 125a. In addition, even if the particles such as the dusts or the Sn particles existing in the light-source-unit chamber 110 are positively (+) charged or not charged, the particles become negatively charged by the electron beams 125a when they move near the barrier module 120a comprised of the plurality of electron beams 125a, thereby preventing the particles from transferring to the mask-unit chamber 115 through the electron beams 125a, by the electrical potential barrier of the barrier module 120a.

The additional barrier module 120b, installed within the mask-unit chamber 115, prevents the particles such as the dusts or the Sn particles existing in the mask-unit chamber 115 from transferring to the mask 135. The additional barrier module 120b may be comprised of a plurality of electron beams 125b like the barrier module 120a. The plurality of electron beams 125b are generated at an electron beam generator 122b, irradiated into the mask-unit chamber 115, and received by an electron beam receptor 124b.

The sub barrier module (not shown), installed around the aperture (e.g., exhaust, wafer handling port etc.) formed on the mask-unit chamber 115, prevents the dusts or the fine particles from transferring to the mask-unit chamber 115 from the outside. The configuration of the sub barrier module is the same as that of the additional barrier module, so a detailed description thereof is omitted.

The particle capturing module 140, installed around the barrier module 120a, captures the particles within the light-source-unit chamber 110. The particle capturing module 140 may be installed around the barrier module 120a, and may be installed in a one-area where the light source for lithography 150 is placed with respect to the barrier module 120a as illustrated in Fig. 1. However, the present disclosure is not limited thereto, and the particle capturing module 140 may be installed in an opposite-area where the light source for lithography 150 is not placed with respect to the barrier module 120a. In addition, the particle capturing module 140 may be installed in both the one-area where the light source for lithography 150 is placed with respect to the barrier module 120a and the opposite-area where the light source for lithography 150 is not placed with respect to the barrier module 120a. Herein, the particle capturing module 140 may be installed in the one-area where the light source for lithography 150 is placed with respect to the barrier module 120a as illustrated in Fig. 1 to capture the particles within the light-source-unit chamber 110, or may be installed in the opposite-area where the light source for lithography 150 is not placed with respect to the barrier module 120a to capture some particles that have passed through the barrier module 120a, thereby preventing the particles from reaching the mask 135.

The particle capturing module 140 may be an electrostatic trap. According to one example embodiment of the present disclosure, one side of the electrostatic trap may be grounded and a positive (+) voltage may be applied to the other side thereof to capture the particles charged with a negative (-) charge by the barrier module 120a comprised of the electron beams 125a. Through this, the electrostatic trap can more easily capture the particles within the light-source-unit chamber 110. When the particle capturing module 140 is installed in this manner, the particles within the light-source-unit chamber 110 can be removed by the particle capturing module 140, thereby preventing the particles from transferring to the mask 135. In particular, when the particle capturing module 140 is installed in the opposite-area where the light source for lithography 150 is not placed with respect to the barrier module 120a, in case the particle capturing module 140 is an electrostatic trap to which a positive (+) voltage is applied, even if the particles charged with a negative (-) charge pass through the barrier module 120a comprised of the electron beams 125a, the particles can be captured by the particle capturing module 140, thereby completely preventing the particles from transferring to the mask 135.

In addition, in Fig. 1, only the case where the particle capturing module 140 is installed around the barrier module 120a is illustrated, but it is not limited thereto, and the particle capturing module 140 may also be installed around the additional barrier module 120b and/or the sub barrier module. Since the particle capturing module 140 installed as such is similar to that installed around the barrier module 120a, a detailed description thereof is omitted.

That is, when the barrier module 120a is configured in the lithography device 100 as in one example embodiment of the present disclosure, the particles such as the dusts or the Sn particles existing in the light-source-unit chamber 110 are prevented from transferring to the mask-unit chamber 115 by the electrical potential barrier rather than the physical barrier. Thus, the dusts are prevented from being attached to the mask 135 during the lithography process. Accordingly, the pellicle is not required in the lithography device 100 according to one example embodiment of the present disclosure, so that a complicated process for manufacturing the pellicle can be omitted. In addition, since the barrier module 120a can be re-used, unlike the pellicle, the cost required for the lithography process is reduced.

In addition, as described above, it is obvious that the device for preventing the movement of the particles by using the electrical potential barrier can be applied not only to the lithography device, but also to devices using various types of vacuum processed chambers that perform deposition processes and etching processes during which it may be problematic if the particles are attached to a substrate. In addition, the particles in the present disclosure may include all types of particles such as the dusts, various types of the fine particles, particles generated during a process, etc.

According to one example embodiment of the present disclosure, by installing the potential barrier made of the electron beams between the chamber where the light source for lithography is installed and the chamber where the mask is placed, the dusts or the fine particles generated during the process and located on the side where the light source for lithography is installed are prevented from transferring to the chamber where the mask is placed, thereby allowing implementation of the lithography device without using the pellicle.

Although the embodiments of the present disclosure have been illustrated and described above, the present disclosure is not limited to the specific embodiments described above, and anyone with ordinary skill in the art to which the present disclosure pertains may make various modifications without departing from the spirit of the present disclosure claimed in the following claims, and such modifications are within the scope of the following claims.

## Claims

1. A lithography device, comprising:
a light-source-unit chamber where a light source for lithography is placed;
a mask-unit chamber where a mask is placed, wherein the mask is irradiated by light generated at the light source for lithography;
a connection unit which connects the light-source-unit chamber with the mask-unit chamber, and through which light generated at the light source for lithography propagates; and
a barrier module which is installed in at least one of the connection unit, the light-source-unit chamber adjacent to the connection unit and the mask-unit chamber adjacent to the connection unit, wherein the barrier module is not a physical barrier but an electrical potential barrier serving to prevent particles located in the light-source-unit chamber from transferring to the mask-unit chamber.

2. The lithography device of Claim 1, wherein the barrier module is installed within the light-source-unit chamber adjacent to the connection unit.

3. The lithography device of Claim 1, further comprising:
an additional barrier module which is installed within the mask-unit chamber, wherein the additional barrier module is not a physical barrier but an electrical potential barrier serving to prevent particles from transferring to the mask which is placed within the mask-unit chamber.

4. The lithography device of Claim 1, wherein at least one aperture connected with outside is formed on the mask-unit chamber,
wherein the lithography device further comprises:
a sub barrier module which is installed around the aperture, wherein the sub barrier module is not a physical barrier but an electrical potential barrier serving to prevent particles from introducing into the mask chamber through the aperture from the outside.

5. The lithography device of any one of Claims 1 to 4, wherein the barrier module includes:
an electron beam generator installed at one side inside the light-source-unit chamber; and
an electron beam receptor installed at an opposite side, facing the one side, inside the light-source-unit-chamber, wherein the electron beam receptor receives electron beams generated by the electron beam generator.

6. The lithography device of any one of Claims 1 to 4, further comprising:
a particle capturing module, installed around the barrier module, which captures the particles.

7. The lithography device of Claim 6, wherein the particle capturing module is installed at least one of a one-area where the light source is placed with respect to the barrier module and an opposite-area where the light source is not placed with respect to the barrier module.

8. The lithography device of Claim 6, wherein the particle capturing module is an electrostatic trap.

9. The lithography device of any one of Claims 1 to 4, wherein the particles are dusts and fine particles which are produced during at least one process.

10. The lithography device of Claim 9, wherein the particles are the dusts and Sn particles.

11. The lithography device of any one of Claims 1 to 4, wherein the light source for lithography is an EUV (Extreme Ultraviolet) light source.
